(19) Europäisches Patentamt
European Patent Office
Office européen des brevets

(11) Publication number : **0 413 565 B1**

(12) # EUROPEAN PATENT SPECIFICATION

(45) Date of publication of patent specification : **25.10.95 Bulletin 95/43**

(51) Int. Cl.$^6$ : **H01L 23/433**, H01L 23/473, C10M 105/50, C10M 107/38

(21) Application number : **90308941.5**

(22) Date of filing : **14.08.90**

(54) **Cooling system for a semiconductor element, semiconductor module including such a system and a thermally conductive member therefor.**

(30) Priority : **18.08.89 JP 211358/89**

(43) Date of publication of application : **20.02.91 Bulletin 91/08**

(45) Publication of the grant of the patent : **25.10.95 Bulletin 95/43**

(84) Designated Contracting States : **DE FR GB NL**

(56) References cited :
**EP-A- 0 288 183**
**PATENT ABSTRACTS OF JAPAN vol. 12, no. 104 (P-685) 06 April 1988 ; & JP-A-62 236 135**
**PATENT ABSTRACTS OF JAPAN vol. 9, no. 236 (P-390) 21 September 1985 ; & JP-A-60 089 817**
**PATENT ABSTRACTS OF JAPAN vol. 12, no. 421 (C-541) 08 November 1988 ; & JP-A-63 150 384**
**PATENT ABSTRACTS OF JAPAN vol. 13, no. 27 (P-815) 20 January 1989 ; & JP-A-63 225 917**
**PATENT ABSTRACTS OF JAPAN vol. 13, no. 69 (C-569) 16 February 1989 ; & JP-A-63 258 992**
**PATENT ABSTRACTS OF JAPAN vol. 12, no. 237 (C-509) 06 July 1988 ; & JP-A-63 027 599**
**PATENT ABSTRACTS OF JAPAN vol. 13, no. 63 (C-568) 13 February 1989 ; & JP-A-63 255 288**
**PATENT ABSTRACTS OF JAPAN vol. 11, no. 192 (C-429) 19 June 1987 ; & JP-A-62 015 295**

(73) Proprietor : **HITACHI, LTD.**
**6, Kanda Surugadai 4-chome**
**Chiyoda-ku, Tokyo 101 (JP)**

(72) Inventor : **Shoji, Mitsuyoshi**
**1621-9, Tomobe,**
**Jyuoh-machi**
**Taga-gun, Ibaraki-ken (JP)**
Inventor : **Morihara, Atsushi**
**42-28, Taisei-cho**
**Katsuta-shi, Ibaraki-ken (JP)**
Inventor : **Nakakawaji, Takayuki**
**1-19-5-404, Ishinazaka-cho**
**Hitachi-shi, Ibaraki-ken (JP)**
Inventor : **Ito, Yutaka**
**1-16, Yamato-cho**
**Takahagi-shi, Ibaraki-ken (JP)**
Inventor : **Komatsuzaki, Shigeki**
**219, Kanaya-cho**
**Mito-shi, Ibaraki-ken (JP)**
Inventor : **Naganuma, Yoshio**
**2-20-1, Mizuki-cho**
**Hitachi-shi, Ibaraki-ken (JP)**
Inventor : **Yokoyama, Hiroshi**
**4-11-7, Ohse-cho**
**Hitachi-shi, Ibaraki-ken (JP)**
Inventor : **Nakagawa, Yusaku**
**2137-23, Tajiri-cho**
**Hitachi-shi, Ibaraki-ken (JP)**

(74) Representative : **Paget, Hugh Charles Edward et al**
**MEWBURN ELLIS**
**York House**
**23 Kingsway**
**London WC2B 6HP (GB)**

EP 0 413 565 B1

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

BACKGROUND OF THE INVENTION

1. FIELD OF THE INVENTION

This invention relates to a cooling system for a semiconductor element, e.g. a semiconductor chip, to a semiconductor module containing a plurality of semiconductor elements cooled by such cooling systems and to a thermally conductive member for use in such a cooling system. The invention is especially useful in the cooling of high-density integrated circuit elements.

2. DESCRIPTION OF THE PRIOR ART

In recently developed large-scale computers, which are required to have a high processing speed, the density of integration of devices has been greatly increased, and the amount of heat generated from one integrated circuit has rapidly increased. As a result, the rise in the temperature of the integrated circuit, which has not been a problem conventionally, has become a matter of concern. Cooling of the integrated circuits has become an important problem in the practical use of a large-scale computer.

A cooling device for use in a large-scale computer system is disclosed in JP-A-63-250848 (1988). A heat conducting intermediate block is slidably mounted on an integrated circuit chip, which is a heat generator, so that the movement of the chip such as thermal expansion and contraction due to the generated heat is absorbed by the transverse or vertical movement of the heat-conducting intermediate block so as to constantly maintain the contact of the cooling portion and the heat generation portion, thereby reducing thermal resistance. A high conductivity grease is used at the contact region, to improve conduction.

EP-A-288 183 illustrates a similar construction having a thermally conductive member slidably arranged between spaced surfaces. It is proposed that a resin is interposed between the member and one of the surfaces.

JP-A-58-91665 (1983) (US-A-4 462 462) discloses another cooling structure in which a cooling piston is slidably mounted on an integrated circuit chip, which is a heat generator. The piston is pushed by a spring so as to keep in close contact. This device is not structurally completed unless a heat transfer grease is used between the cooling piston and a heat transfer cylinder in which the piston is located and which is cooled by a refrigerant carrier, and between the cooling piston and the integrated circuit chip, but an appropriate contact pressure is applied by a spring and a good heat transfer property is obtained.

In the prior art, since the integrated circuit chip generates a considerable amount of heat during operation, thermal expansion and contraction are generated so that minute sliding is generated in the heat transfer surfaces. If there is no lubrication, wear debris is produced on the sliding portion, in other words, dust is produced. Since the wear debris enlarges the gap of the sliding portion and increases the contact heat resistance, heat transfer is extremely reduced. Furthermore, if conductive wear debris drops on the semiconductor element, various troubles may be caused.

To avoid this, in the cooling devices disclosed in JP-A-55-6888 (1980) and JP-A-58-91665 (1983), a special heat transfer grease is used to improve the lubricating property, but these devices are disadvantageous in that the grease is not stable, so that evaporated oil from the grease contaminates the interior of the mounted module and in that it is difficult to maintain a lubricating property for a long time because, if the grease is exposed to a high temperature for a long time, the oil content therein is reduced and the grease is thereby hardened.

SUMMARY OF THE INVENTION

Accordingly, it is an object of the present invention to provide a cooling system for a semiconductor element which is suitable, especially, for a large-scale computer. More particularly, it is an object of the present invention to provide a method of improving the lubricating property of a heat transfer block which undergoes slight sliding preferably without impairing the heat transfer property thereof.

According to the invention there is provided a cooling system for cooling a semiconductor element according to Claim 1 comprising a heat sink and a heat flow path for removing heat from the element to said heat sink. The heat flow path includes two opposed spaced surfaces, one of said surfaces being in thermal connection with said heat sink, the other surface being in thermal connection with said semiconductor element, and an intermediate thermally conductive member interposed between the two surfaces for conducting the heat between the two surfaces and slidable relative to at least one of the surfaces at a region of sliding contact. At the region of sliding contact either or both of the thermally conductive member and the surface contacted

thereby carries a fixed thin film comprising fluorine-containing lubricant.

According to the invention there is further provided a thermally conductive member as set out in Claim 20.

The present invention can provide improvement of the lubricating property of the cooling system without impairing the heat transfer property.

The thin film comprising fluorine containing lubricant is preferably not more than 5 μm, more preferably 2 nm to 100 nm thick.

Preferably the intermediate thermally conductive member has such a thin film comprising fluorine containing lubricant on at least one of its surfaces. The thin film may additionally or alternatively be provided on a surface engaged by the intermediate member, e.g. a surface of a block cooled by a coolant.

In the thin film comprising fluorine-containing lubricant, the lubricant may be chemically bonded to the surface carrying the thin film. Thus the lubricant may constitute the film. Alternatively, the thin film may comprise a support layer, e.g. an organic polymer formed in situ, and fluorine-containing lubricant molecularly anchored in the support layer.

In the first case, the chemical bonding to the surface may be provided by a silanol type bond. The preferred thickness of the film is 2 to 10 nm in this case. As an example of a fluorine compound having a silanol group at the end, a compound represented by the following general formula is preferred:

$$Rf - R - R' - S$$

wherein Rf represents a perfluoropolyoxyalkyl group, R a divalent group selected from an amido group, an ester group and a methylol group, R′ an alkylene group, amino-substituted alkylene group or an aromatic group-substituted alkylene group, and S a silanol group. When such a fluorine compound having a silanol group is heated to for example about 120°C, the silanol group at the end reacts with and becomes fixed on the heat transfer surface, thereby providing a lubricating property.

The silanol group S may typically be Si-OR or $Si(OR)_2$ etc., and typically reacts with -OH groups on the surface of the metal or ceramic member to which the lubricant is bonded to form silanol linkage (Si-O-X, where X is the substrate). A fixed lubricant thin film is thus achieved, providing excellent lubrication and high heat conductivity.

Specific examples of preferred fluorine compounds containing a silanol group at the end are fluorine compounds having the following structures:

$$Rf - CONH - C_3H_6 - Si(OC_2H_5)_3,$$
$$Rf - CONH - C_2H_4NHC_3H_6 - Si(OCH_3)_2(CH_3),$$
$$Rf - CONH - C_2H_4NHC_3H_6 - Si(OCH_3)_3,$$
$$Rf - CH_2O - C_3H_6 - Si(OCH_3)_3,$$
$$Rf - COO - C_3H_6 - OC_3H_6 - Si(OCH_3)_3.$$

In the second case of forming a support layer, e.g. organic coating layer, on the heat transfer surface, preferably, the fluorine-containing lubricant has a molecular structure comprising a first part having a fluoropolyether chain and a second part having greater affinity with said layer than said first part, said second part being anchored in said layer.

Preferred fluorine-containing compounds to be anchored in the surface of the support layer are compounds represented by the following formula:

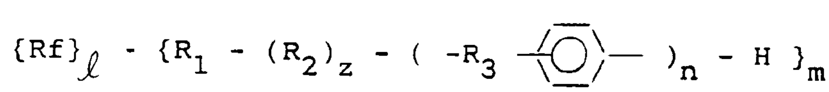

or the general formula:

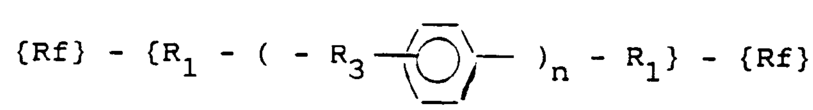

wherein ℓ represents monovalence or bivalence, m is an integer corresponding to ℓ, z is 0 or 1, n is an integer not less than 1, Rf is perfluoropolyoxylalkyl group, $R_1$ a chemical group selected from the group consisting of an amido group, an ester group and a methylol group, $R_2$ an oxyalkylene group having 2 or 3 carbon atoms, and $R_3$ a direct bond or a divalent group selected from an ether group, carbonyl group, ester group, amido group, oxyalkylene group and alkylene group, and may be different at every occurrence. Such a fluorine-containing compound may be applied to the appropriate heat transfer surface in the form of a coating mixed with an agent for forming the support layer. The agent for forming the support layer may be any suitable one and any selected

from the group consisting of polyester, epoxy, phenol, urethane, polyamide, polyimide, vinyl chloride and polyvinyl butyral film forming agents or a mixture thereof is usable.

As examples of fluorine-containing compounds to be anchored in the support layer, the fluorine compounds having the following structures are preferred:

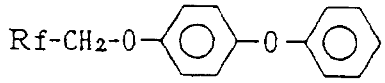,

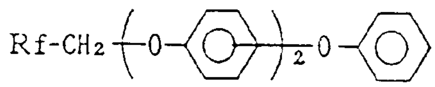,

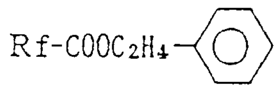,

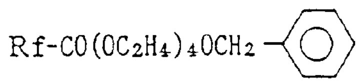,

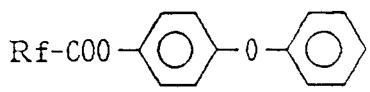,

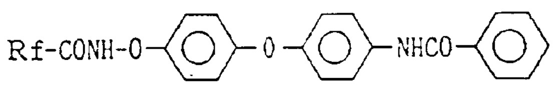,

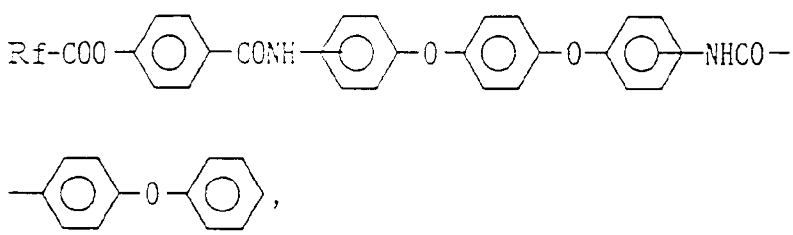,

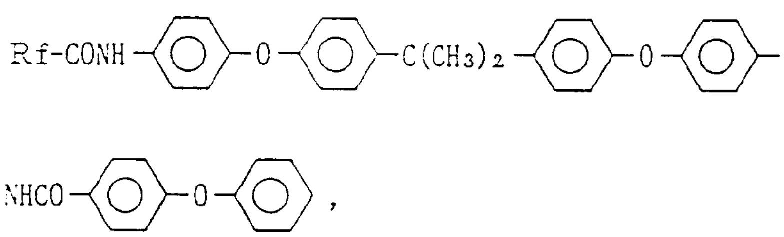,

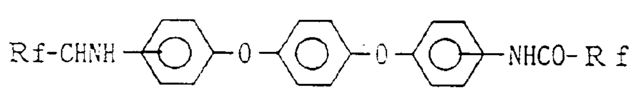,

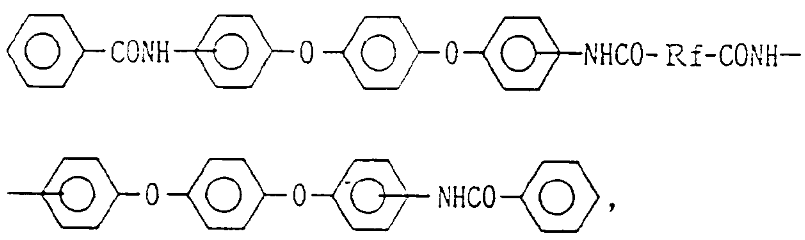

wherein Rf represents a perfluoropolyoxyalkyl group. More specifically, a group of preferred materials are those derived from Krytox 157FS produced by DU PONT or Fomblin Z-DIAC produced by MONTEFLUOS. Krytox 157 FS is $F(CF(CF_3)\text{-}CF_2\text{-}O)_n\text{-}C_2F_4\text{-}COOH$ (where n = 5-100) and Fomblin Z-DIAC is $HOOC\text{-}(C_3F_6O)_{10}\text{-}(CF_2O)_6\text{-}COOH$.

Fluorine-containing lubricant compounds useful in the present invention of the types described above and methods of making them are disclosed in the following Japanese patent applications: JP-A-63-239167 (1988), JP-A-64-56688 (1989), JP-A-1-004950 (1989) and JP-A-1-088918 (1989). Uses of the lubricants disclosed are for magnetic recording media and photosensitive bodies.

By providing a fluorine-containing lubricating thin film in accordance with the present invention on a heat conducting block, for example, by coating the surface of the heat conducting intermediate block disclosed in JP-A-63-250848 mentioned above and shown in Fig. 1 hereof with the lubricating thin film, wear debris is not produced even by the sliding between the block and the integrated circuit chip, thereby enabling the lubricating property to be maintained for a long period.

In one particularly preferred form of the invention, a thin layer of thermally conductive grease is provided at the region of sliding contact. The grease improves thermal transfer between the contacting surfaces especially when one of the surfaces is curved. Preferably the grease has a thermal conductivity of at least 0.4 W/mK. This case of providing a fluorine-containing lubricant and a heat transfer grease is particularly preferred when the substrate carrying the lubricant is of metal. This solves a problem in the prior art. More specifically, although the metal surface generally corrodes when the water content and the additive in the heat transfer grease comes into contact with the metal surface, since the surface is coated with the fluorine-containing lubricant in the present invention, corrosion is reduced or avoided on the metal surface. Consequently, the thermal conduction remains high. This advantage applies particularly when the thin film comprising a support layer as described above is employed and may apply also when a ceramic, such as AlN which is liable to attack by water in the grease, is the substrate. Although the greases of high thermal conductivity described above are preferred, conventional greases may alternatively be employed.

The surface to which the thin film comprising fluorine-containing lubricant is bonded may be metal or ceramic. Electrically insulating ceramic materials are preferable, because being insulating a chipping from them is less likely to affect the semiconductor element. Preferred ceramics are AlN, SiC and $Si_3N_4$. Preferred metals are copper and copper alloys.

Thus advantages obtainable with the present invention are the reduction of wear at the sliding surfaces, combined with good thermal transfer. Particularly, the heat conduction is not reduced by wear. Another advantage is the avoidance of corrosion by grease, when grease is used. The reduction of friction obtained leads to better fitting of the surfaces to each other, so that heat flow is better, and a lower force is required to maintain contact of the sliding surfaces. The use of a lower force is in itself advantageous, since it reduces wear yet further and reduces the risk of damage to a sensitive semiconductor element.

BRIEF INTRODUCTION OF THE DRAWINGS

Embodiments of the invention will now be described by way of non-limitative example with reference to the accompanying drawings, in which:-

Fig. 1 is a partial sectional view of a semiconductor module embodying the present invention;

Fig. 2 is a cutaway general view of a semiconductor module having a large number of semiconductor elements cooled by cooling systems of the present invention;

Fig. 3 is a graph showing the relationship between the variation in the thickness of a semiconductor element and the thermal resistance in a cooling structure according to the present invention;

Fig. 4 is a graph showing the relationship between the inclination of a semiconductor element and the thermal resistance in a cooling structure according to the present invention;

Fig. 5 schematically shows a testing apparatus used for measuring the sliding properties between the heat transfer members in a cooling system according to the present invention; and

Figs. 6 and 7 show the results of the sliding tests of cooling systems according to the present invention, showing the relationship between the number of reciprocations and the amount of dust produced.

DESCRIPTION OF THE PREFERRED EMBODIMENTS

The structure of the cooling system shown in Fig. 1 will be described first. Fig. 1 shows part of a semiconductor module composed of a wiring substrate 1, a plurality of semiconductor elements 2 mounted on the substrate 1, only one element 2 being shown in Fig. 1, and a heat conducting intermediate block 3 of aluminium nitride, which has a high heat conductivity. The element 2 is connected to the substrate 1 by a plurality of solder connecting members 4. The block 3 is movable and makes sliding contact with the rear surface of the element 2. The block 3 is movably connected to a fixed heat transfer block 6 by a spring member 5. The block 3 also slidably contacts the heat transfer block 6, which itself is disposed in thermal contact with a coolant body 7 containing a water coolant passage.

The blocks 3 and 6 may be of metal or ceramic. Suitable materials are given above and in the Examples.

Electric signals and power which are input to the substrate 1 through pins 8 are supplied to the semiconductor element 2 through the connecting members 4. The semiconductor element 2 is highly integrated so as to increase its computing speed, and since a large amount of current is supplied to a very small area, a large amount of heat is generated by the semiconductor element.

Since the thermal resistance of the connecting members 4, the substrate 1 and the pins 8 are too large to pass the large amount of heat generated in this way through the connecting members 4, it is necessary to release the heat from the rear side of the element 2.

The heat conducting intermediate block 3 is a trigonal prism with the flat bottom surface 9 and with a cylindrically curved upper surface 10. Other curvatures than cylindrical may be used. Preferably the curvature is in one direction, which means the same as the curvature is in one plane, i.e. the curved surface can be defined by moving a curve which lies in a single plane perpendicularly to that plane. A recess 11 is provided in the other inclined surface and the spring 5 is located in the recess 11. At the opposite end of this spring 5, the transfer heat block 6 has a similar recess 12.

The large amount of heat generated from the semiconductor elements 2 is transferred from the bottom surface 9 of the block 3 which is in contact with the rear side of the semiconductor element 2. The block 3 may be surrounded by a gas having a high heat conductivity, e.g. helium gas, for the purpose of good heat transfer.

The block 6 is provided with a V-shaped groove having a shape similar to that of the block 3. One surface of the V-shaped groove is a flat surface 6a with which the curved upper surface 10 of the block 3 comes into sliding contact.

The heat transferred to the intermediate block 3 is transferred from the upper surface 10 to the flat surface 6a of the V-shaped groove. The gas having a high heat conductivity assists good heat transfer at this region also.

The coolant body 7 is disposed on the upper surface of the heat transfer block 6. Coolant for releasing the heat generated from the elements 2 to the outside of the system flows in the coolant unit 7. Heat transfer occurs via the contact of the bottom surface of the coolant unit 7 and the upper surface of the heat transfer block 6.

Fig. 2 shows the cooling system of Fig. 1 applied to a semiconductor module having a large number of the elements 2 which are typically semiconductor chips. The elements 2 are mounted in common on the wiring substrate 1, and the pins 8 project into holes 14 in a support board 15 in conventional manner. On the substrate 1 is also mounted the body 7 providing a housing which, with the substrate 1, hermetically encloses the elements 2 and the heat transfer blocks 3. The cooling water passages in the housing body 7 are indicated at 16. In practice, the housing body 7 may be in several parts sealed together and with appropriate thermal contact ensured. A cooling water inlet and outlet 17 are indicated. Warm water may be used, to avoid condensation.

In the module structure, the heights and inclinations of the elements 2 vary among the elements 2 due to the non-uniformity in the production of the substrate 1, the attachment of the connecting members 4, etc. In the cooling structure of the invention, however, the heat conducting intermediate block 3 flexibly moves so as to achieve in each case face contact between the upper surface of the element 2 and the intermediate block 3 and the line contact between the bottom surface 6a of the heat transfer block 6 and the curved surface 10 of the intermediate block 3, thereby realizing good heat transfer, even though there is non-uniformity in the height and inclination of the semiconductor element 2.

In order to follow the non-uniformity in the height of the element 2, the intermediate block 3 can move under the action of the spring 5 parallel to the upper rear surface of the element 2 and perpendicularly to the axis of curvature of the curved surface 10 of the intermediate block 3. In other words, when the gap between the element 2 and the heat transfer block 6 becomes large, the intermediate block 3 moves along the element 2, thereby compensating for the non-uniformity in height.

In order to follow the non-uniformity in the inclination of the element 2, the intermediate block 3 rotates. It can rotate about the axis of curvature of the curved surface 10, and about an axis perpendicular to the rear face 9 of the element 2. When the element 2 is inclined, the line contact of the curved surface 10 of the intermediate block 3 and the bottom surface of the block 6 is maintained.

This arrangement of the movable heat transfer block 3 is fully described in EP-A-354722 to which reference should be made.

To improve the sliding of the intermediate block 3 on the element 2 and the block 6, the block 3 has thin films 13 comprising fluorine-containing lubricant fixed on its opposite surfaces 9,10. These films 13 have been described generally above and will be illustrated below. The surface 6a of the block 6 may carry a similar surface.

The opposite surfaces of the intermediate block 3 contacting the semiconductor element 2 and the block 6 are considered to be at an angle $\theta$, since in practice the curvature of the surface 40 is small. The angle $\theta$ is an important factor in determining the heat transfer characteristics and the movement characteristics of the intermediate block 3. The larger the angle $\theta$, the more the heat transfer area (the contact area between the intermediate block 3 and the heat transfer block 6) increases, but the more the gap between the heat transfer block 6 and the semiconductor element 2 disadvantageously enlarges. If it is assumed that the depth of the intermediate block 3 is H, its width is L, the total thermal resistance RT of the inclined portion is represented by the following equation:

$$RT = \frac{\tan(\theta)}{kbH} + \frac{1}{hHL(1 + \tan(\theta)^2)^{1/2}}$$

wherein kb represents the heat conductivity of the intermediate block 3, and h a heat transfer coefficient. The first term on the right-hand side represents a thermal resistance at the contacting surface and the second term the thermal resistance of the intermediate block 3. The optimum angle is selected on the basis of the thermal conductivity of the intermediate block 3, the heat transfer coefficient at the contacting surface, etc. obtained from the above equation.

The calculation of the performance of the cooling structure of this embodiment and the results of using the cooling structure will be explained with reference to Figs. 2 and 3. Fig. 3 shows the influence of the change of height of the substrate 1 due to heat or the like on the thermal resistance. The solid line indicates the calculated value and the plotted points indicate the measured values. Fig. 4 shows the change of thermal resistance with the inclination of the semiconductor element 2 due to warping or the like which is caused by heat. Fig. 3 shows that the line contact is adequately maintained even if the height of the substrate of the elements 2 changes by about 1 mm and that the thermal resistance is constant. If the angle of inclination of the semiconductor element 2 is about 1 degree, the line contact is adequately maintained, and the thermal resistance is constant, thereby producing no problem in practical use.

The cooling structure of this invention has a high reliability.

Non-limitative Examples of the invention will now be given.

Example 1

Heat conducting intermediate blocks 3 of aluminium nitride of the cooling system of Fig. 1 were washed by an ultrasonic cleaner filled with a trifluorotrichloroethane solution, and thoroughly dried after washing. The thus-prepared intermediate blocks 3 were dipped in trifluorotrichloroethane solutions containing 0.2 wt% of various fluorine lubricants each having a silanol group at one end of its molecule, as shown in Table 1 dissolved therein so as to coat the surface of the intermediate block 3 in each case with the respective fluorine lubricant, and thereafter heat-treated at 120°C for 5 minutes. The intermediate block 3 was then washed by an ultrasonic cleaner filled with a trifluorotrichloroethane solution so as to remove the surplus fluorine lubricant.

Table 1

| Lubricant | Molecular structure of lubricant |
|---|---|
| 1 | $F(C_3F_6O)_{14}$ - $CONH-C_3H_6$ - $Si(OC_2H_5)_3$ |
| 2 | $F(C_3F_6O)_{14}$ - $CH_2-O-C_3H_6-Si(OCH_3)_3$ |
| 3 | $F(C_3F_6O)_{29}$ $COO-C_3H_6-O-C_3H_6-Si(OCH_3)_3$ |

The thickness of the completed film was about 5 nm. The lubricating property of the thus-obtained intermediate blocks 3 was evaluated by a dust producing test which measures the amount of dust produced during minute sliding. The dust testing apparatus is schematically shown in Fig. 5. On a reciprocating disk 21, an aluminum nitride plate 22 having a surface roughness (Ra) of 0.1 μm was fixed and the heat conducting intermediate block 3 subjected to lubrication treatment was pressed against the plate 22 with a given load. The resultant wear debris 24 produced was collected by a silicon wafer 23 placed under the slightly reciprocating disk 21. The amount of wear debris on the silicon wafer, namely, the amount of dust produced was measured by a laser surface inspecting device (produced by Hitachi, Ltd. Type: HLD-300b) together with the particle diameter of the dust.

The thermal resistance of each block 3 was measured by incorporating the block 3 with its surface treated with a lubricant into a cooling structure.

As comparison for the evaluation of the lubricating property and the thermal resistance, the same heat conducting intermediate block 3 without lubrication treatment was also tested. The thermal resistance thereof when incorporated into the cooling structure was also measured.

The results of the dust producing test are shown in Fig. 6. From Fig. 6, it is observed that the amount of dust produced by the intermediate blocks 3 with the surface treated with the fluorine lubricant having a silanol at the end was very small at the initial state as compared with the material without lubrication treatment, and that the lubricating property was improved to a great extent. From the results of the measurements of the thermal resistance shown in Table 2, it is observed that the thermal resistance was scarcely increased with the lubrication treatment, which was proved to be an excellent surface treatment.

Table 2

| Lubricant No. | Thermal Resistance (K/W) |
|---|---|
| 1 | 0.75 |
| 2 | 0.78 |
| 3 | 0.77 |
| Comparison | 0.75 |

Example 2

Heat conducting intermediate blocks 3 of AlN for the cooling system of Fig. 1 were washed by an ultrasonic cleaner filled with a trifluorotrichloroethane solution, and thoroughly dried after washing. Each was then given a different lubricant film, as follows.

Solution 1 was prepared by dissolving 4.8 g of an epoxy resin EP1004 (trade name: produced by Du Pont), 0.88 g of a phenol resin Hitanol 1501 (trade name: produced by Hitachi Chemical Company, Ltd.) and a hardening accelerator, 0.06g of triethylammonium carbonate TEA-KI (trade name: produced by Hokko Chemical Industrial Co., Ltd.) into 200 g of methyl ethyl ketone. Solution 2 was prepared in each case by dissolving a solution of 0.56 g of a fluorine compound shown in Table 3 in 10 g of methyl ethyl ketone into Solution 1.

TABLE 3

| Lubricant No. | Molecular structure of lubricant |
|---|---|
| 4 | 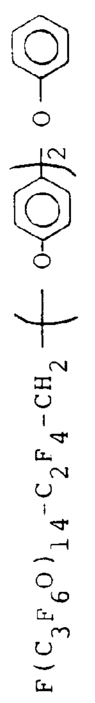 |
| 5 | 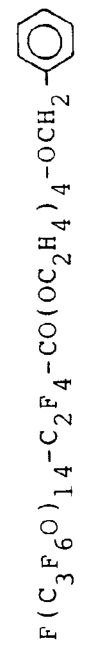 |
| 6 | 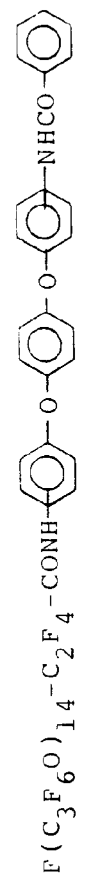 |
| 7 | 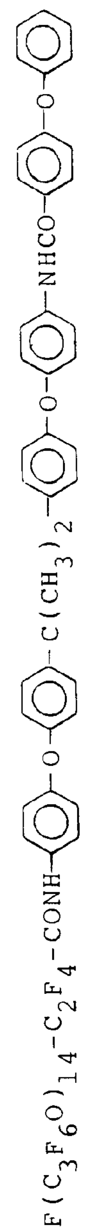 |
| 8 | 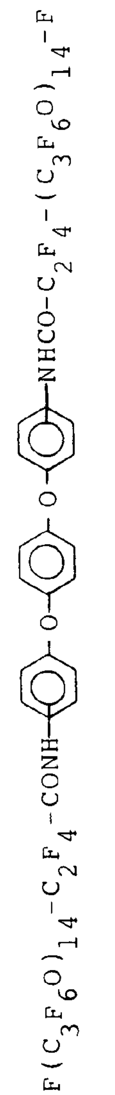 |
| 9 | 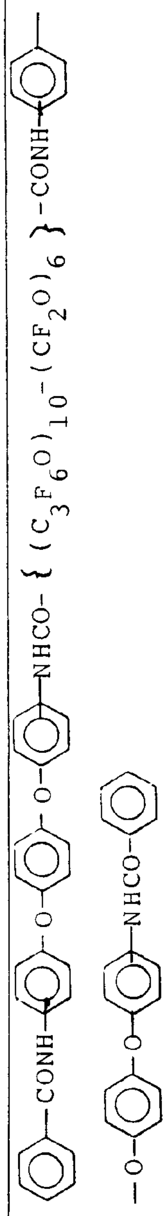 |

The intermediate block 3 washed as described was dipped in the thus-prepared solution 2, taken out of the solution and heat-treated at 230°C for 60 minutes. The block 3 was then washed by an ultrasonic cleaner

filled with a trifluorotrichloroethane solution. The resultant lubricant film consisted of a binder or support layer 20 nm thick and a thin upper layer 4 nm thick of the fluorine-containing lubricant anchored to the binder layer. The lubricating property of the thus-obtained block 3 was evaluated by the dust producing test in the same way as in Example 1 and the thermal resistance thereof incorporated into the cooling structure was also measured.

As comparison, the same heat conducting intermediate block 3 without lubrication treatment was used, as in Example 1.

The results of the dust producing test are shown in Fig. 7. From Fig. 7, it is observed that the amount of dust produced by the blocks 3 with the treated surface was very small at the initial stage as compared with the material without lubrication treatment, and that the lubricating property was improved to a great extent. From the results of the measurements of the thermal resistance shown in Table 4, it is observed that the thermal resistance was scarcely increased with the lubrication treatment, which was thus proved to be an excellent surface treatment.

Table 4

| Lubricant No. | Thermal Resistance (K/W) |
|---|---|
| 4 | 0.77 |
| 5 | 0.80 |
| 6 | 0.77 |
| 7 | 0.74 |
| 8 | 0.82 |
| 9 | 0.75 |
| Comparison | 0.75 |

Example 3

Heat conducting intermediate blocks 3 of a cooling system of Fig. 1 were produced from pure copper, washed by an ultrasonic cleaner filled with a trifluorotrichloroethane solution, and thoroughly dried after washing. For each block, a solution 2 containing a fluorine compound shown in Table 3 as prepared in the same way in Example 2. The washed and dried block 3 of pure copper in each case was dipped in the solution 2, taken out of the solution and heat-treated at 230°C for 60 minutes. The block 3 was then washed by an ultrasonic cleaner filled with a trifluorotrichloroethane solution.

The thickness of the completed lubricant layer was about 25 nm. The lubricating property of the thus-obtained block 3 of pure copper was measured by incorporating it into the cooling structure and heat transfer grease YG6240S (trade name: produced by Toshiba Silicon, Ltd, thermal conductivity 0.84 W/mK) was provided at the contact region between the block 3 and the element 2 (LSI device), and at the contact region between the block 3 and the heat transfer block 6.

The thermal resistance of the resultant cooling structure and the state of corrosion of the block 3 of pure copper were observed. The corrosion state was judged by observing whether or not there was a change in the color of the surface of the block 3 of pure copper.

As comparison for the evaluation of the corrosion state, the same block 3 without surface treatment was used. As comparison for the thermal resistance, the same heat conducting intermediate block 3 without surface treatment was used.

The results of the observation of the corrosion state are shown in Table 5 and the results of the measurements of the thermal resistance are shown in Table 6. From Table 5, it is observed that no colour change was produced in the blocks 3 of pure copper due to corrosion and that the surface lubrication treatment in accordance with the present invention gives an excellent corrosion-resistant film coating. As to the thermal resistance, it is observed from Table 6 that an excellent cooling structure is produced by using the heat conducting intermediate block 3 of pure copper and heat transfer grease. In the case of the Comparison example, the presence of the corrosion increases the thermal resistance.

Table 5

| Lubricant No. | Corrosion State of Surface |
|---|---|
| 4 | No colour change |
| 5 | No colour change |
| 6 | No colour change |
| 7 | No colour change |
| 8 | No colour change |
| 9 | No colour change |
| Comparison | Colour was changed to blue black |

Table 6

| Lubricant No. | Thermal Resistance (K/W) |
|---|---|
| 4 | 0.53 |
| 5 | 0.53 |
| 6 | 0.52 |
| 7 | 0.53 |
| 8 | 0.53 |
| 9 | 0.53 |
| Comparison | 0.75 |

Other examples of greases having a thermal conductivity greater than 0.4 W/mK useful in the invention are

| Trade Name | Manufacturer | Thermal Conductivity (W/mK) |
|---|---|---|
| SH 340 | Toray Silicon Ltd. | 0.42 |
| KS 612 | Shinetsu Kagaku Ltd. | 0.61 |
| FSXM 3001 | Dow Corning Co. | 0.79 |

Example 4

Heat conducting intermediate blocks 3 of AlN for the cooling system of Fig. 1 were washed by an ultrasonic cleaner filled with a trifluorotrichloroethane solution and thoroughly dried after washing. The blocks 3 were then dipped in trifluorotrichloroethane solutions containing in each case 0.2 wt% of fluorine-lubricant having a silanol end group as shown in Table 1 dissolved therein so as to coat the surface thereof, and thereafter heat-treated at 120°C for 5 minutes. The block 3 was then washed by an ultrasonic cleaner filled with a trifluorotrichloroethane solution so as to remove the surplus fluorine lubricant. The thickness of the completed film was about 5 nm. The intermediate block 3 so obtained was incorporated into the cooling structure and heat transfer grease (trade name: YG6240S, product of Toshiba Silicon, Ltd.) was provided at the contact region between the heat conducting intermediate block 3 and the element 2 (LSI chip) and at the contact region

with the heat transfer block 6. The thermal resistance of the heat conducting intermediate block thus incorporated in the cooling structure was measured.

As comparison, the same heat conducting intermediate block without lubricating treatment, was used as in Example 1. The results of the heat resistance measurement indicate that the heat resistance is small and the surface treatment is excellent as shown in Table 7.

Table 7

| Lubricant No. | Thermal resistance (K/W) |
|---|---|
| 1 | 0.61 |
| 2 | 0.63 |
| 3 | 0.63 |
| Comparison | 0.75 |

Example 5

Heat conducting intermediate blocks 3 of pure copper were used, and as in Example 4 a fluorine lubricant layer having a silanol end group was formed on each block 3. Each block 3 was then incorporated into the cooling structure of Fig. 1 and heat transfer grease (trade name: YG6240S, product of Toshiba Silicon, Ltd.) was provided at the contact regtion between the heat conducting intermediate block 3 and the element 2 (LSI chip) and at the contact region with the heat transfer block 6. The thermal resistance of the cooling structure and the state of surface corrosion of the heat conducting intermediate block 3 of pure copper were observed. The corrosion state was judged by observing whether or not there was a change in the colour of the surface of the block 3 of pure copper.

As comparison for the evaluation of the corrosion state, the same heat conducting intermediate block 3 without surface treatment was used.

The results of the observation of the corroded state are shown in Table 8 and the results of the measurements of the thermal resistance are shown in Table 9. From Table 8, it is observed that no colour change was produced in the block 3 of pure copper of the invention due to corrosion and that the surface lubrication treatment in accordance with the present invention provides an excellent corrosion-resistant film coating. As to the thermal resistance, it is observed from Table 9 that an excellent cooling structure is produced by using the heat conducting intermediate block 3 of pure copper and heat transfer grease.

Table 8

| Lubricant No. | Thermal resistance (K/W) |
|---|---|
| 1 | 0.53 |
| 2 | 0.53 |
| 3 | 0.53 |
| Comparison | 0.75 |

Table 9

| Lubricant No. state | Surface corroded |
|---|---|
| 1 | No colour change |
| 2 | No colour change |
| 3 | No colour change |
| Comparison | Colour was changed to blue black |

Example 6

In the same manner as in Example 2, a fixed lubricant film of binder layer having a thickness of 20 nm and a lubricant layer having a thickness of about 4 nm were formed on heat conducting intermediate blocks 3 of AlN. Each block 3 was then incorporated into the cooling structure of Fig. 1 and heat transfer grease (trade name: YG6240S, product of Toshiba Silicon, Ltd.) was provided on the contact surface between the block 3 and the element 2 (LSI chip) and on the contact surfaces with the heat transfer block 6. The thermal resistance of the block 3 thus incorporated in the cooling structure was measured.

As comparison, the same heat conducting intermediate block without lubricating treatment was used. The results of the heat resistance measurement indicate that the heat resistance scarcely increases even with the lubrication treatment as shown in Table 10.

Table 10

| Lubricant No. | Thermal resistance (K/W) |
|---|---|
| 4 | 0.75 |
| 5 | 0.76 |
| 6 | 0.73 |
| 7 | 0.72 |
| 8 | 0.77 |
| 9 | 0.75 |
| Comparison | 0.75 |

## Claims

1. A cooling system for cooling a semiconductor element (2) comprising a heat sink (6, 7) and a heat flow path for removing heat from the said element to said heat sink, said heat flow path including two opposed spaced surfaces, one of said surfaces being in thermal connection with said heat sink, the other surface being in thermal connection with said semiconductor element, and a thermally conductive member (3) interposed between said two spaced surfaces (6a) for conducting the heat between said two surfaces and slidable relative to at least one of said spaced surfaces at a region of sliding contact, characterized in that at said region of sliding contact at least one of said thermally conductive member (3) and the said surface (6a) contacted thereby carries a thin film (13) comprising fluorine-containing lubricant fixed thereto.

2. A cooling system according to claim 1 wherein said thin film (13) has a thickness not greater than 5 μm.

3. A cooling system according to claim 2 wherein said thin film (13) has a thickness in the range 2 nm to 100 nm.

4. A cooling system according to any one of claims 1 to 3 wherein said fluorine-containing lubricant is chemically bonded to the surface carrying it.

5. A cooling system according to claim 4 wherein said chemical bonding is provided by silanol type bonding.

6. A cooling system according to claim 4 or claim 5 wherein the thickness of said film (13) is in the range 2 to 10 nm.

7. A cooling system according to claim 4 wherein said fluorine-containing compound is represented by the following general formula:

$$Rf - R - R' - S$$

wherein Rf represents a perfluoropolyoxyalkyl group, R represents a divalent chemical group selected from the group consisting of an amido group, an ester group and a methylol group, R′ represents a chemical group selected from the group consisting of an alkylene group, an amino-substituted alkylene group and an aromatic group-substituted alkylene group, and S represents a silanol group.

8. A cooling system according to any one of claims 1 to 3 wherein said thin film (13) comprises said fluorine-containing lubricant and a support layer therefor fixed to the surface carrying said thin film, molecules of said lubricant being anchored in said support layer.

9. A cooling system according to claim 8 wherein said layer is a cured resin layer.

10. A cooling system according to claim 8 or claim 9 wherein said fluorine-containing compound is represented by the following general formula:

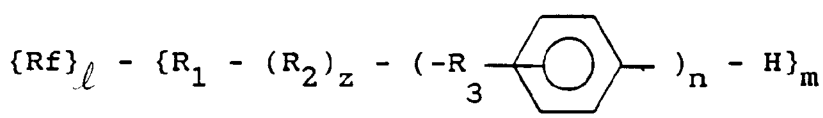

wherein $\ell$ represents monovalence or bivalence of Rf, m is an integer corresponding to $\ell$, z is 0 or 1, n is an integer not less than 1, Rf is a perfluoropolyoxyalkyl group, $R_1$ is a divalent chemical group selected from the group consisting of an amido group, an ester group and a methylol group, $R_2$ is an oxyalkylene group having 2 or 3 carbon atoms, and $R_3$ is a direct bond or a divalent chemical group selected from the group consisting of an ether group, carbonyl group, ester group, an amido group, an oxyalkylene group and an alkylene group and may be different at each occurrence.

11. A cooling system according to claim 8 or claim 9 wherein said fluorine-containing compound is represented by the following general formula:

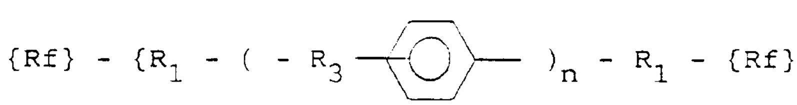

wherein n is an integer not less than 1, Rf is a perfluoropolyoxyalkyl group, $R_1$ is a divalent chemical group selected from the group consisting of an amido group, an ester group and a methylol group, and $R_3$ is a direct bond or a divalent chemical group selected from the group consisting of an ether group, a carbonyl group, an ester group, an amido group, an oxyalkylene group and an alkylene group and may be different at each occurrence.

12. A cooling system according to any one of claims 8 to 11 wherein said fluorine-containing lubricant has a molecular structure comprising a first part having a fluoropolyether chain and a second part having greater affinity with said support layer than said first part, said second part being anchored in said support layer.

13. A cooling system according to any one of the preceding claims wherein said thin film (13) is on said thermally conductive member (3).

14. A cooling system according to any one of the preceding claims wherein a layer of thermally conductive grease is provided between said thermally conductive member and said surface contacted thereby.

15. A cooling system according to claim 14 wherein said grease has a thermal conductivity of at least 0.4 W/mK.

16. A cooling system according to any one of claims 1 to 15 wherein said thermally conductive member (3) and said spaced surface (6a) contacted thereby make line contact with each other, and said system further has a spring (5) urging said thermally conductive member into contact with said spaced surface contacted thereby.

17. A cooling system according to any one of claims 1 to 16 wherein at least one of said thermally conductive member (3) and said spaced surface (6a) contacted thereby are of metal.

18. Apparatus comprising at least one semiconductor device (2), a coolant passage (16) for coolant to cool said semiconductor device and a cooling structure according to any one of claims 1 to 17 providing a heat flow path from said semiconductor device to said coolant passage.

19. A semiconductor module having a plurality of semiconductor devices (2) mounted on a common base (1) and a cooling body (7) for said devices, including at least one flow passage (16) for coolant, and for each said semiconductor element, a cooling system according to claim 1 providing a heat flow path from the semiconductor device to said coolant passage.

20. A thermally conductive member for use in a cooling system for a semiconductor device according to Claim 1, comprising a body (3) having on opposite sides a first surface which is planar and a second surface which is curved with curvature in a single direction, characterized in that at least one of said surfaces has thereon a thin film (13) comprising a fluorine-containing lubricant fixed to said member.

21. A thermally conductive member according to claim 20 wherein said thin film (13) is on said curved surface.

## Patentansprüche

1. Kühlsystem zur Kühlung eines Halbleiterelements (2), umfassend einen Kühlkörper (6, 7) und einen Wärmeströmungsweg zur Abführung von Wärme aus dem Element zum Kühlkörper, wobei der Wärmeströmungsweg zwei gegenüberliegende, im Abstand voneinander angeordnete Oberflächen, von denen eine in thermischer Verbindung mit dem Kühlkörper und die andere in thermischer Verbindung mit dem Halbleiterelement steht, und ein thermisch leitendes Element (3) aufweist, das zwischen den beiden im Abstand voneinander angeordneten Oberflächen (6a) zur Wärmeleitung zwischen den beiden Oberflächen angeordnet ist und verschiebbar in bezug zu mindestens einer der im Abstand voneinander angeordneten Oberflächen in einem Gleitkontaktbereich angeordnet ist, dadurch gekennzeichnet, daß im Gleitkontaktbereich mindestens einer der Bestandteile thermisch leitendes Element (3) und damit in Kontakt stehende Oberfläche (6a) eine daran fixierte dünne Schicht (13) mit einem Gehalt an einem fluorhaltigen Gleitmittel aufweist.

2. Kühlsystem nach Anspruch 1, wobei die dünne Schicht (13) eine Dicke von nicht mehr als 5 μm aufweist.

3. Kühlsystem nach Anspruch 2, wobei die dünne Schicht (13) eine Dicke im Bereich von 2 nm bis 100 nm aufweist.

4. Kühlsystem nach einem der Ansprüche 1 bis 3, wobei das fluorhaltige Gleitmittel chemisch an die Oberfläche, auf der es sich befindet, gebunden ist.

5. Kühlsystem nach Anspruch 4, wobei die chemische Bindung durch eine Bindung vom Silanoltyp gewährleistet wird.

6. Kühlsystem nach Anspruch 4 oder 5, wobei die Dicke der Schicht (13) im Bereich von 2-10 nm liegt.

7. Kühlsystem nach Anspruch 4, wobei die fluorhaltige Verbindung durch die nachstehende allgemeine Formel wiedergegeben wird:

$$Rf - R - R' - S$$

worin Rf eine Perfluorpolyoxyalkylgruppe bedeutet, R einen zweiwertigen chemischen Rest aus der Gruppe Amidorest, Esterrest und Methylolrest bedeutet, R′ einen chemischen Rest aus der Gruppe Alkylenrest, aminosubstituierter Alkylenrest und mit einer aromatischen Gruppe substituierter Alkylenrest bedeutet

und S einen Silanolrest bedeutet.

8. Kühlsystem nach einem der Ansprüche 1-3, wobei die dünne Schicht (13) das fluorhaltige Gleitmittel und eine Trägerschicht dafür, die an der die dünne Schicht tragenden Oberfläche fixiert ist, aufweist, wobei die Moleküle des Gleitmittels in der Trägerschicht verankert sind.

9. Kühlsystem nach Anspruch 8, wobei es sich bei der Schicht um eine gehärtete Harzschicht handelt.

10. Kühlsystem nach Anspruch 8 oder 9, wobei die fluorhaltige Verbindung durch die nachstehende allgemeine Formel wiedergegeben wird:

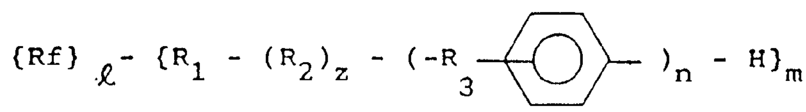

worin 1 eine einwertige oder zweiwertige Beschaffenheit von Rf bedeutet, m eine ganze Zahl entsprechend dem Wert von 1 bedeutet, z den Wert 0 oder 1 hat, n eine ganze Zahl, die nicht kleiner als 1 ist, bedeutet, Rf einen Perfluorpolyoxyalkylrest bedeutet, $R_1$ einen zweiwertigen chemischen Rest aus der Gruppe Amidorest, Esterrest und Methylolrest bedeutet, $R_2$ einen Oxyalkylenrest mit 2 oder 3 Kohlenstoffatomen bedeutet und $R_3$ eine direkte Bindung oder einen zweiwertigen chemischen Rest aus der Gruppe Etherrest, Carbonylrest, Esterrest, Amidorest, Oxyalkylenrest und Alkylenrest bedeutet und bei jedem Auftreten eine unterschiedliche Bedeutung haben kann.

11. Kühlsystem nach Anspruch 8 oder 9, wobei die fluorhaltige Verbindung durch die folgende allgemeine Formel wiedergegeben wird:

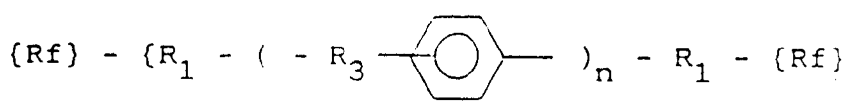

wobei n eine ganze Zahl, die nicht unter 1 liegt, bedeutet, Rf einen Perfluorpolyoxyalkylrest bedeutet, $R_1$ einen zweiwertigen chemischen Rest aus der Gruppe Amidogruppe, Estergruppe und Methylolgruppe bedeutet und $R_3$ eine direkte Bindung oder einen zweiwertigen chemischen Rest aus der Gruppe Etherrest, Carbonylrest, Esterrest, Amidorest, Oxyalkylenrest und Alkylenrest bedeutet und bei jedem Auftreten eine unterschiedliche Bedeutung haben kann.

12. Kühlsystem nach einem der Ansprüche 8-11, wobei das fluorhaltige Gleitmittel eine Molekülstruktur aufweist, die einen ersten Teil mit einer Fluorpolyetherkette und einen zweiten Teil aufweist, dessen Affinität zur Trägerschicht größer als die des ersten Teils ist, wobei der zweite Teil in der Trägerschicht verankert ist.

13. Kühlsystem nach einem der vorstehenden Ansprüche, wobei sich die dünne Schicht (13) auf dem thermisch leitenden Element (3) befindet.

14. Kühlsystem nach einem der vorstehenden Ansprüche, wobei eine Schicht eines thermisch leitenden Schmierfettes zwischen dem thermisch leitenden Element und der mit dieser in Kontakt stehenden Oberfläche vorgesehen ist.

15. Kühlsystem nach Anspruch 14, wobei das Schmiermittel eine Wärmeleitfähigkeit von mindestens 0,4 W/mK aufweist.

16. Kühlsystem nach einem der Ansprüche 1-15, wobei das thermisch leitende Element (3) und die damit in Kontakt stehende, einen Abstand aufweisende Oberfläche (6a) miteinander einen Leitungskontakt herstellen und wobei das System ferner eine Feder (5) aufweist, die das wärmeleitende Element in Kontakt mit der damit kontaktierten, im Abstand angeordneten Oberfläche drückt.

17. Kühlsystem nach einem der Ansprüche 1-16, wobei mindestens einer der Bestandteile wärmeleitendes Element (3) und damit kontaktierte, im Abstand angeordnete Oberfläche (6a) aus Metall sind.

18. Vorrichtung, umfassend mindestens eine Halbleitervorrichtung (2), einen Kühlmitteldurchgang (16) für ein Kühlmittel zur Abkühlung der Halbleitervorrichtung und eine Kühlstruktur nach einem der Ansprüche 1-17, die einen Wärmeströmungsweg von der Halbleitervorrichtung zum Kühlmitteldurchgang gewährleistet.

19. Halbleitermodul mit einer Mehrzahl von auf einer gemeinsamen Grundplatte (1) befestigten Halbleitervorrichtungen (2) und einem Kühlkörper (7) für diese Vorrichtungen, umfassend mindestens einen Strömungsdurchgang (16) für Kühlmittel und für jedes einzelne Halbleiterelement ein Kühlsystem nach Anspruch 1, das einen Wärmeströmungsweg von der Halbleitervorrichtung zum Kühlmitteldurchgang bereitstellt.

20. Wärmeleitendes Element zur Verwendung in einem Kühlsystem für eine Halbleitervorrichtung nach Anspruch 1, umfassend einen Körper (3), der auf gegenüberliegenden Seiten eine erste planare Oberfläche und eine zweite gekrümmte Oberfläche mit einer Krümmung in einer einzigen Richtung aufweist, dadurch gekennzeichnet, daß auf mindestens einer der Oberflächen eine dünne Schicht (13), die ein fluorhaltiges Gleitmittel, das an diesem Element fixiert ist, umfaßt, vorhanden ist.

21. Wärmeleitendes Element nach Anspruch 20, wobei sich die dünne Schicht (13) auf der gekrümmten Oberfläche befindet.

## Revendications

1. Système de refroidissement pour refroidir un élément semi-conducteur (2) comprenant un puits thermique (6, 7) et une voie de circulation de la chaleur pour dissi-per la chaleur dudit élément vers ledit puits thermique, ladite voie de circulation de la chaleur comprenant deux surfaces espacées opposées, une desdites surface étant en liaison thermique avec ledit puits thermique, l'autre surface étant en liaison thermique avec ledit élément semi-conducteur, et un élément thermiquement conducteur (3) interposé entre lesdites deux surfaces espacées (6a) pour conduire la chaleur entre lesdites deux surfaces et pouvant glisser par rapport à au moins une desdites surfaces espacées dans une région de contact glissant, caractérisé en ce que dans ladite région de contact glissant, au moins l'un dudit élément thermiquement conducteur (3) et de ladite surface (6a) ainsi en contact, porte un film mince (13) comprenant un lubrifiant contenant du fluor fixé à celui-ci.

2. Système de refroidissement selon la revendication 1, dans lequel ledit film mince (13) présente une épaisseur ne dépassant pas 5 μm.

3. Système de refroidissement selon la revendication 2, dans lequel ledit film mince (13) présente une épaisseur dans l'intervalle de 2 nm à 100 nm.

4. Système de refroidissement selon l'une quelconque des revendications 1 à 3, dans lequel ledit lubrifiant contenant du fluor est chimiquement lié à la surface qui le porte.

5. Système de refroidissement selon la revendication 4, dans lequel ladite liaison chimique est assurée par une liaison de type silanol.

6. Système de refroidissement selon la revendication 4 ou 5, dans lequel l'épaisseur dudit film (13) varie dans l'intervalle de 2 nm à 10 nm.

7. Système de refroidissement selon la revendication 4, dans lequel ledit composé contenant du fluor est représenté par la formule générale suivante :

$$Rf - R - R' - S$$

dans laquelle Rf représente un groupe perfluoropolyoxy-alkyle, R représente un groupe chimique divalent choisi parmi un groupe amido, un groupe ester et un groupe méthylol, R′ représente un groupe chimique choisi parmi un groupe alkylène, un groupe alkylène substitué par un ou des groupes amino et un groupe

alkylène substitué par un ou des groupes aromatique(s), et S représente un groupe silanol.

**8.** Système de refroidissement selon l'une quelconque des revendications 1 à 3, dans lequel ledit film mince (13) comprend ledit lubrifiant contenant du fluor et une couche support pour celui-ci, fixée à la surface portant ledit film mince, des molécules dudit lubrifiant étant ancrées à ladite couche support.

**9.** Système de refroidissement selon la revendication 8, dans lequel ladite couche est une couche de résine durcie.

**10.** Système de refroidissement selon la revendication 8 ou 9, dans lequel ledit composé contenant du fluor est représenté par la formule générale suivante :

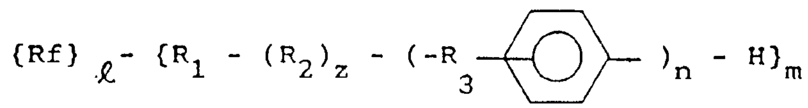

dans laquelle représente la monovalence ou la bivalence de Rf, m est un nombre entier correspondant à , z est égal à 0 ou à 1, n est un nombre entier qui n'est pas inférieur à 1, Rf représente un groupe perfluoropolyoxyalkyle, $R_1$ représente un groupe chimique divalent choisi parmi un groupe amido, un groupe ester et un groupe méthylol, $R_2$ représente un groupe oxyalkylène ayant 2 ou 3 atomes de carbone, et $R_3$ est une liaison directe ou un groupe chimique divalent choisi parmi un groupe éther, un groupe carbonyle, un groupe ester, un groupe amido, un groupe oxyalkylène et un groupe alkylène et peut être différent à chaque fois qu'il apparaît.

**11.** Système de refroidissement selon la revendication 8 ou 9, dans lequel ledit composé contenant du fluor est représenté par la formule générale suivante :

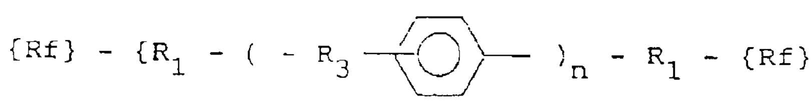

dans laquelle n est un nombre entier qui n'est pas inférieur à 1, Rf représente un groupe perfluoropolyoxyalkyle, $R_1$ représente un groupe chimique divalent choisi parmi un groupe amido, un groupe ester et un groupe méthylol, et $R_3$ est une liaison directe ou un groupe chimique divalent choisi parmi un groupe éther, un groupe carbonyle, un groupe ester, un groupe amido, un groupe oxyalkylène et un groupe alkylène et peut être différent à chaque fois qu'il apparaît.

**12.** Système de refroidissement selon l'une quelconque des revendications 8 à 11, dans lequel ledit lubrifiant contenant du fluor présente une structure moléculaire comprenant une première partie ayant une chaîne fluoropolyéther et une seconde partie ayant une plus grande affinité avec ladite couche support que ladite première partie, ladite seconde partie étant ancrée à ladite couche support.

**13.** Système de refroidissement selon l'une quelconque des revendications précédentes, dans lequel ledit film (13) est sur ledit élément thermiquement conducteur (3).

**14.** Système de refroidissement selon l'une quelconque des revendications précédentes, dans lequel une couche de graisse thermiquement conductrice est placée entre ledit élément thermiquement conducteur et ladite surface à son contact.

**15.** Système de refroidissement selon la revendication 14, dans lequel ladite graisse présente une conductivité thermique d'au moins 0,4 W/mK.

**16.** Système de refroidissement selon l'une quelconque des revendications 1 à 15, dans lequel ledit élément thermiquement conducteur (3) et ladite surface espacée (6a) ainsi en contact sont en contact linéaire l'un avec l'autre, et ledit système a en outre un ressort (5) poussant ledit élément thermiquement conducteur

au contact de ladite surface espacée ainsi en contact.

**17.** Système de refroidissement selon l'une quelconque des revendications 1 à 16, dans lequel au moins l'un dudit élément thermiquement conducteur (3) et de ladite surface espacée (6a) ainsi en contact est en métal.

**18.** Appareil comprenant au moins un dispositif semi-conducteur (2), un passage de produit réfrigérant (16) pour le produit réfrigérant destiné à refroidir ledit dispositif semi-conducteur et une structure de refroidissement selon l'une quelconque des revendications 1 à 17 fournissant une voie de circulation de la chaleur dudit dispositif semi-conducteur audit passage de produit réfrigérant.

**19.** Module à semi-conducteurs comprenant plusi-eurs dispositifs semiconducteurs (2) montés sur un support commun (1) et un corps réfrigérant (7) pour lesdits dispositifs , comprenant au moins un passage de circulation (16) pour le produit réfrigérant, et pour chacun desdits éléments semi-conducteurs, un système de refroidissement selon la revendication 1, fournissant une voie de circulation de la chaleur dudit dispositif semi-conducteur audit passage de produit réfrigérant.

**20.** Elément thermiquement conducteur destiné à être utilisé dans un système de refroidissement pour un dispositif semi-conducteur selon la revendication 1, comprenant un corps (3) ayant sur ses côtés opposés une première surface qui est plane et une seconde surface qui est incurvée dans un seul sens, caractérisé en ce qu'au moins une desdites surfaces porte un film mince (13) comprenant un lubrifiant contenant du fluor fixé audit élément.

**21.** Elément thermiquement conducteur selon la revendication 20, dans lequel ledit film mince (13) est sur ladite surface incurvée.

Fig.1

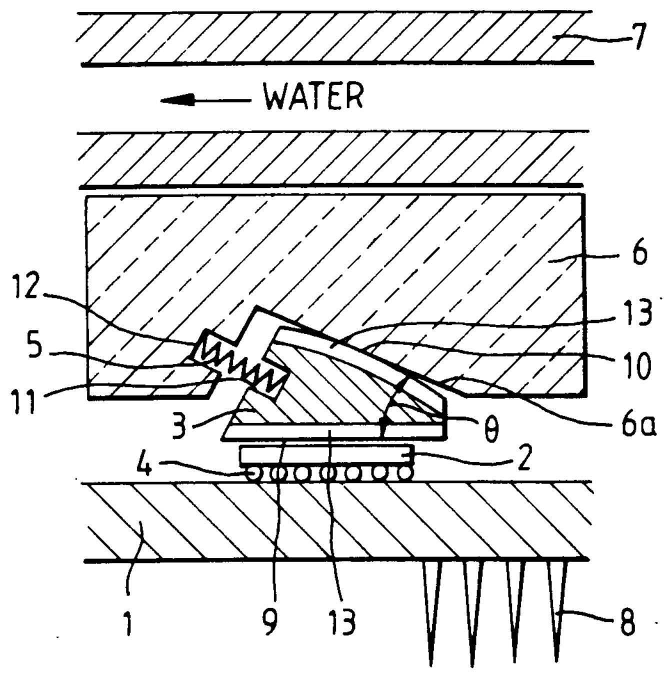


Fig.2

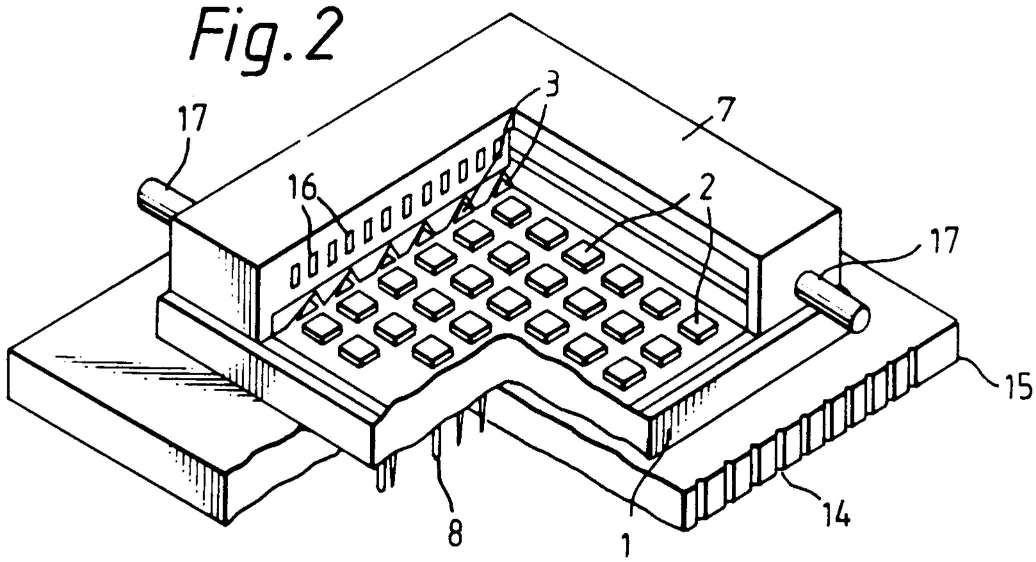

Fig. 3

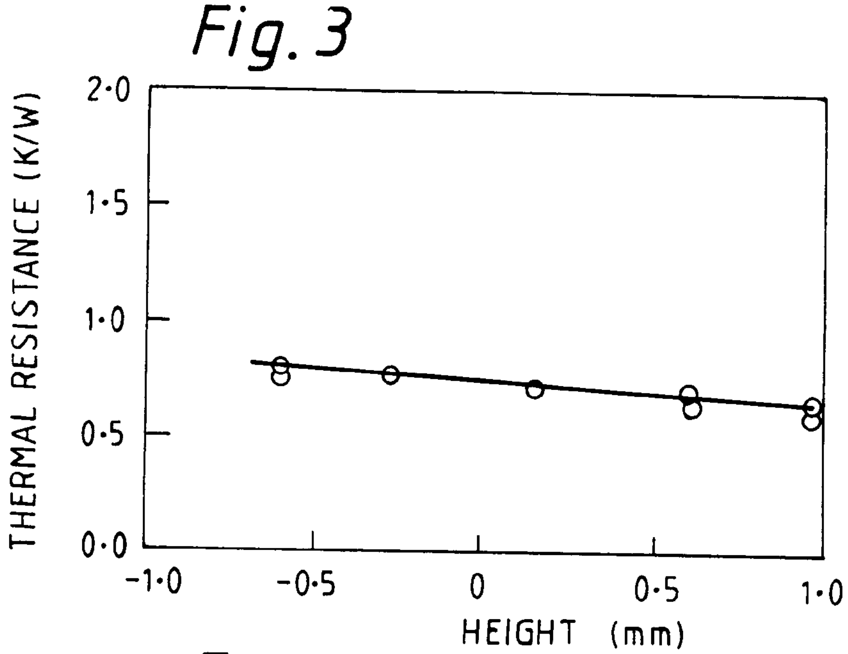


Fig. 4

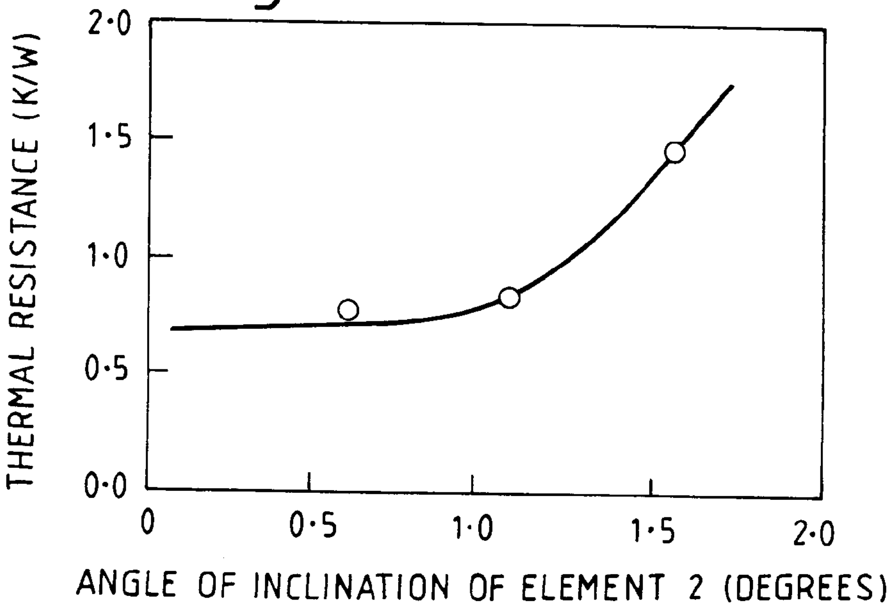


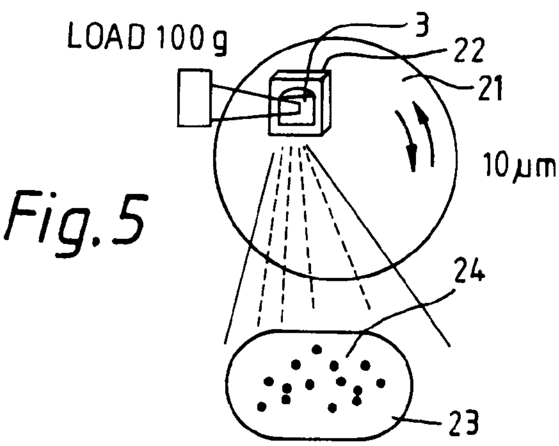


Fig. 5

Fig. 6

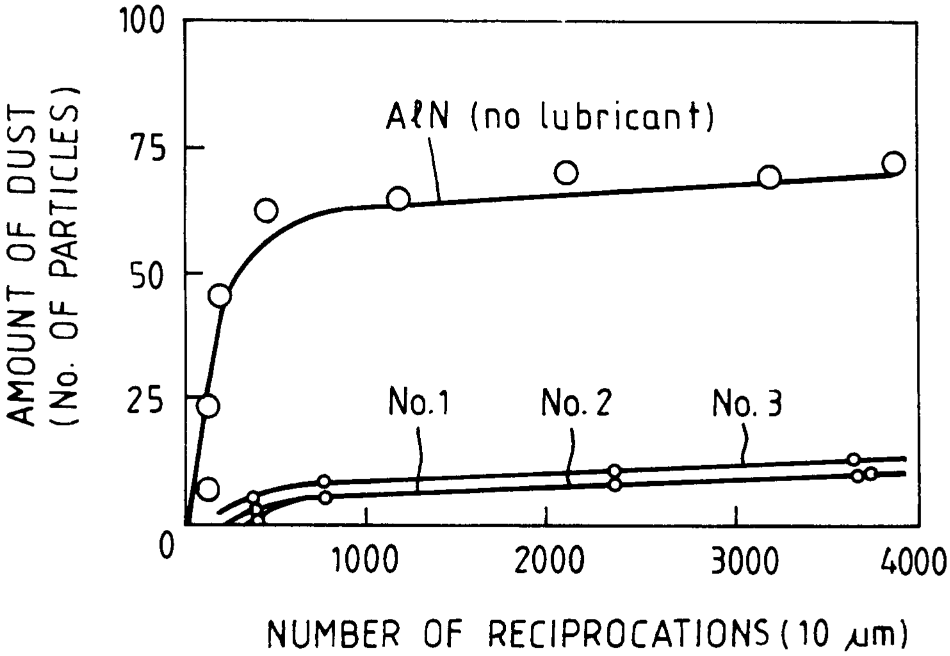
100
75
50
25
0
AMOUNT OF DUST
(No. OF PARTICLES)
AℓN (no lubricant)
No.1
No. 2
No. 3
1000
2000
3000
4000
NUMBER OF RECIPROCATIONS (10 μm)

Fig. 7

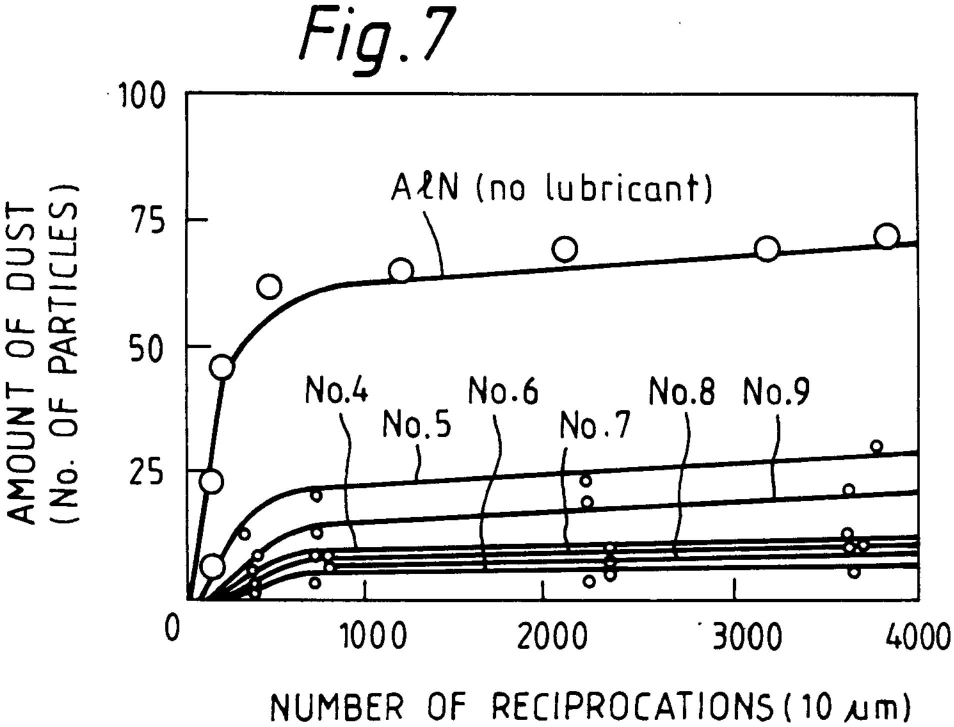
100
75
50
25
0
AMOUNT OF DUST
(No. OF PARTICLES)
AℓN (no lubricant)
No.4
No.5
No.6
No.7
No.8
No.9
1000
2000
3000
4000
NUMBER OF RECIPROCATIONS (10 μm)